Europäisches Patentamt

European Patent Office

Office européen des brevets

(19)

(11) **EP 0 523 595 B1**

(12) **EUROPÄISCHE PATENTSCHRIFT**

(45) Veröffentlichungstag und Bekanntmachung des Hinweises auf die Patenterteilung:
**25.09.1996  Patentblatt 1996/39**

(51) Int Cl.$^6$: **H03H 21/00**

(21) Anmeldenummer: **92111913.7**

(22) Anmeldetag: **13.07.1992**

(54) **Schaltungstechnische Realisierung des adaptiven normalisierten Schur-RLS-Lattice-Filters**

Realization of a normalized adaptive Schur-RLS-Lattice filter

Réalisation d'un filtre adaptatif normalisé en échelle du type Schur-RLS-Lattice

(84) Benannte Vertragsstaaten:
**DE FR GB**

(30) Priorität: **19.07.1991  DE 4124052**

(43) Veröffentlichungstag der Anmeldung:
**20.01.1993  Patentblatt 1993/03**

(73) Patentinhaber: **SIEMENS AKTIENGESELLSCHAFT**
**80333 München (DE)**

(72) Erfinder: **Strobach, Peter, Dr.-Ing.**
**W-8000 München 83 (DE)**

(56) Entgegenhaltungen:
- **IEEE SIGNALPROCESSING MAGAZINE Januar 1991, Seiten 12-36; P.STROBACH: 'New Forms of Levinson and Schur Algorithms'**
- **IEEE TRANSACTIONS ON ACOUSTICS, SPEECH AND SIGNAL PROCESSING Bd. 38, Nr. 3, März 1990, New York, US, Seiten 397-405, XP000116520; KOSTAS BERBERIDIS et al.: 'A Normalized Lattice Algorithm for AR Spectral Analysis and System Identification Filters with Symmetric Impulse Response'**
- **PROCEEDINGS OF THE IEEE Bd. 70, Nr. 8, August 1982, New York, US, Seiten 829-867; B.FRIEDLANDER: 'Lattice Filters for Adaptive Processing'**

EP 0 523 595 B1

**Beschreibung**

Adaptive Filter spielen in der modernen Nachrichtentechnik eine wichtige Rolle. Sie dienen der Modellierung von zeitvarianten Systemen oder Prozessen und können daher beispielsweise zur Entzerrung des extrem zeitvarianten Übertragungskanals beim Mobilfunkempfang eingesetzt werden.

In nachrichtentechnischen Anwendungen sollen adaptive Filter bei sehr hohen Datenraten (100 Mhz und mehr) in Echtzeit betrieben werden. Die Echtzeitrealisierung adaptiver Filterverfahren bei extremen Datenraten erfordert besonders strukturierte Verfahren. Unter der Vielzahl der bisher entwickelten adaptiven Filterverfahren gewinnen daher diejenigen Methoden zunehmend an Bedeutung, deren Rekursionsgleichungen sich vollständig parallelisieren und in Form systolischer Architekturen realisieren lassen. Eine Übersicht über den aktuellen Stand der Technik bei adaptiven Filtern findet man in [1].

Die genannte Forderung der vollständigen Parallelisierbarkeit wird bereits durch das unnormalisierte Schur-RLS-Lattice-Filter [1,2] erfüllt. Dieses Verfahren ist durch die algorithmische Beschreibung in Tabelle 1 eindeutig bestimmt.

Das Verfahren gemäß der algorithmischen Beschreibung in Tabelle 1 wird in jedem Zeitschritt aus den Momenten 2. Ordnung $\{c_o(t), c_1(t), \ldots, c_N(t)\}$ eines adaptiv zu filternden Signals, sowie dem Signalwert $x(t)$ initialisiert. Das Verfahren berechnet daraus das Restsignal $e_m(t)$. Das Verfahren führt die Berechnungen bis zu einer maximalen Ordnung N durch.

Für das Verfahren läßt sich eine schaltungstechnische Realisierung angeben. Diese wurde bereits in [1] und [2] beschrieben. Diese schaltungstechnische Realisierung basiert darauf, die Berechnungen gemäß Tabelle 1 auf verfahrensspezifische Elementarprozessoren zu verteilen. Es sind insgesamt 2 elementare Prozessortypen erforderlich.

Erstens ein Prozessor zur $2 \times 2$ Matrix-Vektor-Multiplikation zum Zweck der Durchführung der Operationen

$$\begin{pmatrix} C^f_{m,j}(t) \\ C^b_{m,j}(t) \end{pmatrix} = \begin{pmatrix} 1 & K^f_m(t) \\ K^b_m(t) & 1 \end{pmatrix} \begin{pmatrix} C^f_{m-1,j}(t) \\ C^b_{m-1,j-1}(t-1) \end{pmatrix}$$

sowie

$$\begin{pmatrix} e_m(t) \\ r_m(t) \end{pmatrix} = \begin{pmatrix} 1 & K^f_m(t) \\ K^b_m(t) & 1 \end{pmatrix} \begin{pmatrix} e_{m-1}(t) \\ r_{m-1}(t-1) \end{pmatrix}$$

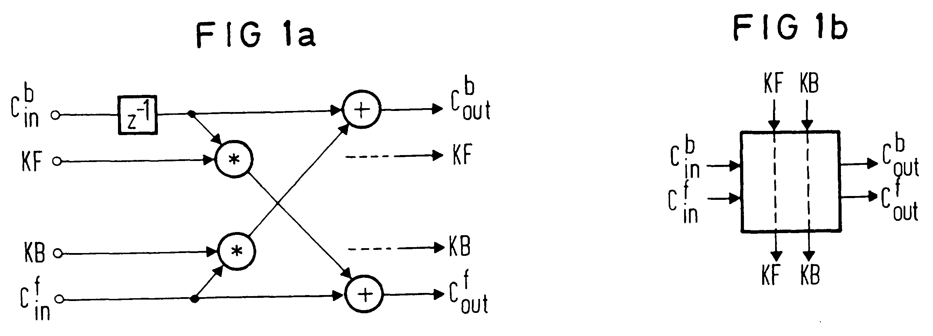

gemäß der algorithmischen Beschreibung aus Tabelle 1. Figur 1a zeigt den inneren Aufbau und Figur 1b zeigt das Blocksymbol dieses Elementarprozessors. Dabei kennzeichnet "*" einen Multiplizierer, "+" kennzeichnet einen Addierer und $z^{-1}$ kennzeichnet ein Register.

Zweitens ein Prozessor zur Durchführung der Operationen

$$K^f_m(t) = -C^f_{m-1,m}(t)/R_{m-1}(t-1)$$

$$K^b_m(t) = -C^f_{m-1,m}(t)/E_{m-1}(t)$$

$$E_m(t) = E_{m-1}(t) + K^f_m(t)\, C^f_{m-1,m}(t)$$

$$R_m(t) = R_{m-1}(t-1) + K^b_m(t)\, C^f_{m-1,m}(t)$$

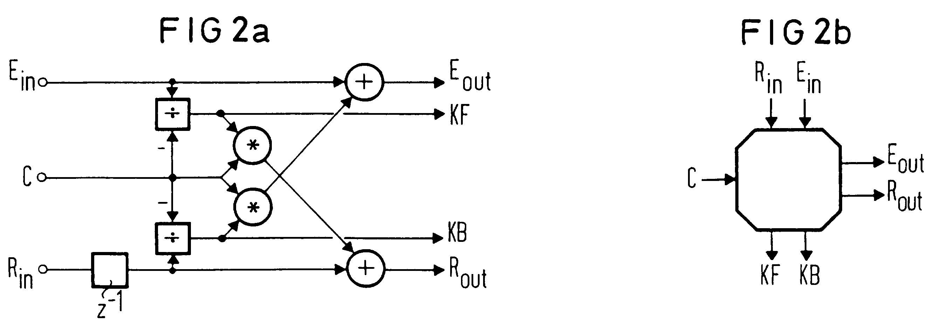

gemäß der algorithmischen Beschreibung aus Tabelle 1. Figur 2a zeigt den inneren Aufbau und Figur 2b zeigt das Blocksymbol dieses Elementarprozessors. Das Symbol ÷ kennzeichnet einen Dividierer.

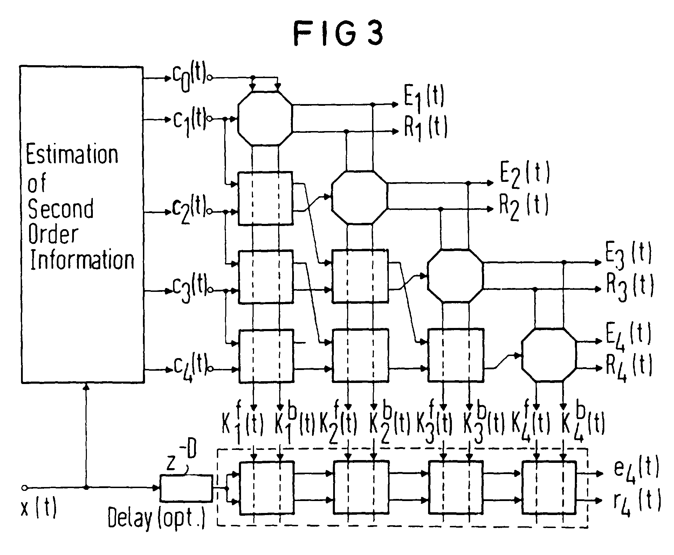

Mit den in Figur 1 und in Figur 2 dargestellten Elementarprozessoren läßt sich eine schaltungstechnische Realisierung der in Tabelle 1 dargestellten algorithmischen Beschreibung angeben. Figur 3 zeigt eine solche schaltungstechnische Realisierung bestehend aus der Zusammenschaltung der in Figur 1 und Figur 2 dargestellten Elementarprozessoren für ein Beispiel der Ordnung N = 4.

Bei der in Figur 3 gezeigten schalltungstechnischen Realisierung wird ein zweiter Elementarprozessor aus den Größen $c_o(t)$ und $c_1(t)$ initialisiert und berechnet daraus die Größen $K^f_1(t)$ und $K^b_2(t)$ welche auf Querbussen durch N darunterliegende erste Elementarprozessoren geleitet werden. Der zweite Elementarprozessor berechnet weiterhin die Größen $E_1(t)$ und $R_1(t)$, die nach außen und an einen weiteren zweiten Elementarprozessor, der rechts-unterhalb gelegen ist. geleitet werden. Dieser zweite Elementarprozessor berechnet nun die Größen $K^f_2(t)$ und $K^b_2(t)$ welche wiederum auf Querbussen durch N -1 darunterliegende Elementarprozessoren geleitet werden. Des weiteren berechnet dieser zweite Elementarprozessor die Größen $E_2(t)$ und $R_2(t)$, die nach außen und an einen nächsten rechtsunterhalb in der Anordnung gelegenen zweiten Elementarprozessor weitergeleitet werden. In dieser Weise setzt sich die Struktur fort bis zu einem N-ten zweiten Elementarprozessor, welcher die Größen $K_N^f(t)$ und $K_N^b(t)$ berechnet und an einen einzigen darunterliegenden ersten Elementarprozessor und die Größen $E_N(t)$ und $R_N(t)$ nach außen weitergibt. Auf diese Weise entsteht die in Figur 1 gezeigte schaltungstechnische Realisierung in Form einer dreiecksförmigen Anordnung bestehend aus N(N+1)/2 elementaren ersten Prozessoren. sowie N elementaren zweiten Prozessoren. In der ersten Spalte der Anordnung werden die obersten N-1 Prozessoren aus den Momenten zweiter Ordnung initialisiert. Die Momente zweiter Ordnung werden in einer Anordnung bezeichnet als "Estimation of Second Order Information" aus dem Eingangssignal x(t) geschätzt. Diese Anordnung zur Berechnung der Momente zweiter Ordnung wird in der Literatur beschrieben [1]. Der unterste Prozessor der ersten Spalte wird aus dem Eingangssignal initialisiert. wobei noch eine Verzögerung um D Taktzeiten, bezeichnet mit "Delay (opt)" vorgeschaltet ist. Die horizontale Verschaltung der ersten Prozessoren innerhalb der dreieckigen Anordnung mit Ausnahme der untersten Prozessorenzeile ist dadurch gekennzeichnet, daß jeweils ein Prozessor über zwei Eingänge und zwei Ausgänge verfügt; die Verschaltung ist weiterhin dadurch gekennzeichnet, daß jeder Prozessor von dem direkt links neben ihm sowie von dem direkt schräg links über ihm gelegenen Nachbarprozessor Daten erhält und ist dadurch gekennzeichnet, daß der Prozessor über den oberen Eingang Daten aus dem oberen Ausgang des schräg links über ihm gelegene Prozessors sowie über den unteren Eingang Daten aus dem unteren Ausgang des links neben ihm gelegenen Prozessors erhält. Die Ausnahme bildet die untere Zeile der Anordnung bestehend aus N Prozessoren, welche direkt horizontal miteinander kommunizieren, indem ein Prozessor über seinen oberen Eingang Daten vom oberen Ausgang und über seinen unteren Eingang Daten vom unteren Ausgang des links neben ihm liegenden Prozessors empfängt.

Das Zusammenwirken der Prozessoren in der beschriebenen schaltungstechnischen Realisierung ist dadurch gekennzeichnet, daß die Prozessoren lokal miteinander kommunizieren. Dabei versteht man unter lokaler Kommunikation einen Datenaustausch zwischen direkt benachbarten oder diagonal direkt benachbarten Prozessoren. Der Datenaustausch ist ferner dadurch gekennzeichnet, daß er einheitlich für alle Prozessoren in einer Richtung (von links nach rechts und diagonal von links oben nach rechts unten) erfolgt. Das Zusammenwirken der Prozessoren in der beschriebenen schaltungstechnischen Anordnung ist ferner dadurch gekennzeichnet, daß sämtliche Prozessoren in der schaltungstechnischen Anordnung mit demselben Systemtakt betrieben werden. Eine Anordnung elementarer Prozessoren, deren Zusammenwirken von diesen Regeln bestimmt wird, nennt man ein systolisches Array.

2. Probleme bei der Ausführung nach dem bisherigen Stand der Technik

Die so beschriebene und in Figur 3 gezeigte schaltungstechnische Realisierung der in Tabelle 1 angegebenen algorithmischen Beschreibung eines unnormalisierten Schur-RLS-Lattice-Filters besitzt die folgenden Nachteile welche eine praktische Realisierung wesentlich erschweren:

1. In jeder Spalte der schaltungstechnischen Realisierung aus Figur 3 sind zwei Querbusse zur Übertragung der Größen $\{K_m^f(t), K_m^b(t); 1 \leq m \leq N\}$ erforderlich. Diese Querbusse sind durch alle Prozessoren zu schleifen. Ihre Realisierung nimmt einen erheblichen Anteil am Gesamtverfahrensaufwand in Anspruch.

2. Die auf den Querbussen zu übertragenden Größen $\{K_m^f(t), K_m^b(t); 1 \leq m \leq N\}$ sind nicht wertebeschränkt. Daher sind die Busse mit einer sehr hohen Anzahl an Datenleitungen auszulegen, um die Anzahl möglicher Überläufe gering zu halten.

3. Die horizontal in der Anordnung übertragenen Größen überstreichen ebenfalls einen für viele Anwendungen zu hohen Wertebereich, so daß für die horizontale Verschaltung ebenfalls zu breite Busse und damit zu viele Datenleitungen erforderlich sind.

4. Der hohe Wertebereich der in horizontalen Richtung übertragenen Großen erfordert Multiplizierer mit großer Wortbreite für die weitere Verarbeitung in den Elementarprozessoren. Jeder erste Elementarprozessor erfordert einen Realisierungsaufwand von 2 Multiplizierern. Neben der in Figur 1 gezeigten Anordnung bestehend aus 2 Multiplizierern gibt es keine alternativen Realisierungsformen für den in Figur 1 gezeigten ersten Elementarprozessor.

Der vorliegenden Patentanmeldung liegt die Aufgabenstellung zugrunde, eine schaltungstechnische Realisierung zur adaptiven Filterung anzugeben, welche die oben genannten Nachteile der in Figur 3 gezeigten Anordnung vermeidet. Dies gelingt mit Hilfe eines wurzelnormalisierten (Square-Root-Normalisierten) Verfahrens und einer zugehörigen schaltungstechnischen Realisierung, welche nachfolgend beschrieben wird.

3. Das wurzelnormalisierte Schur-RLS-Lattice-Filter

Das wurzelnormalisierte Schur-RLS-Lattice-Filter ist durch die in Tabelle 2 angegebene algorithmische Beschreibung eindeutig bestimmt. Das wurzelnormalisierte Schur-RLS-Lattice-Filter ist dadurch gekennzeichnet, daß es durch die wurzelnormalisierten Momente zweiter Ordnung definiert durch

$$\bar{c}_j(t) = c_j(t) \, c_o^{-1/2}(t), \, 1 \le j \le N \, ;$$

initialisiert wird.

Die normalisierten Gröben $\bar{c}_j(t)$ sind durch einen wesentlich geringeren Wertebereich gekennzeichnet, als die ursprünglichen (unnormalisierten) Größen $c_j(t)$.

Das wurzelnormalisierte Schur-RLS-Lattice-Filter gemäß der algorithmischen Beschreibung in Tabelle 2 ist darüber hinaus dadurch gekennzeichnet, daß das zu filternde Eingangssignal x(t) ebenfalls wurzelnormalisiert und in die Signale $v_o(t)$ und $w_o(t)$ übergeführt wird:

$$v_o(t) = w_o(t) = x(t) \, c_o^{-1/2}(t).$$

Das wurzelnormalisierte Schur-RLS-Lattice-Filter gemäß der algorithmischen Beschreibung in Tabelle 2 ist darüber hinaus dadurch gekennzeichnet, daß sämtliche Operationen in die folgende elementare Form gebracht werden können:

$$\begin{pmatrix} \times \\ \\ \times \end{pmatrix} = \left[ 1 - \rho_m^2(t) \right]^{-1/2} \begin{pmatrix} 1 & \rho_m(t) \\ \\ \rho_m(t) & 1 \end{pmatrix} \begin{pmatrix} \times \\ \\ \times \end{pmatrix} \, .$$

Diese elementare Operation ist durch die Größe $\rho_m(t)$ eindeutig bestimmt. Diese Größe übernimmt im normalisierten Verfahren dieselbe Funktion wie die Größen $K_m^f(t)$ und $K_m^b(t)$ im unnormalisierten Verfahren. gemäß der algorithmischen Beschreibung aus Tabelle 1.

Diese Elementaroperation besitzt darüber hinaus die wichtige Eigenschaft, daß sie eine hyperbolische Transformation darstellt und daher in einfacher Weise multiplikationsfrei mit einem CORDIC-Prozessor [3] realisiert werden kann.

Das normalisierte Verfahren ist darüber hinaus dadurch gekennzeichnet, daß die Größe $\rho_m(t)$ wertebeschränkt betragsmäßig kleiner gleich eins ist:

$$\left| \rho_m(t) \right| \le 1.$$

Weiterhin ist es bekannt, den Dynamikbereich eines Prozessors besser auszunutzen, in dem alle Variablen geeignet normalisiert sind. Aus demselben Dokument ist es ferner bekannt, daß die Fehlervariablen durch ihre entsprechenden Varianten normalisiert werden können, so daß die normalisierten Größen < 1 aufweisen (K. Berberidis et al, A Normalized Lattice Algorithm for AR Spectral Analysis and System Identification Filters with Symmetric Impulse Response, IEEE Transactions on Acoustics, Speech and Signal Processing, Bd. 38, Nr. 3, März 1990, New York, USA, Seiten 397 bis 405, XP 000116520, 1990).

Die Zeichnungen stellen ein Ausführungsbeispiel der Erfindung dar, das im folgenden näher beschrieben wird. Es zeigen

Figuren 1a und 1b den inneren Aufbau (Figur 1a) und das Blocksymbol (Figur 1b) eines Elementarprozessors, also eine schaltungstechnische Realisierung der algorithmischen Beschreibung aus Tabelle 1;

Figuren 2a und 2b den inneren Aufbau (Figur 2a) und ein Blocksymbol (Figur 2b) einen weiteren Elementarprozessor als schaltungstechnische Realisierung der algorithmischen Beschreibung aus Tabelle 1;

Figur 3 eine Blockschaltung, die eine Zusammenschaltung der in Figuren la und 2a dargestellten Elementarprozessoren für ein Beispiel der Ordnung N = 4;

Figuren 4a und 4b den inneren Aufbau (Figur 4a) und das Blocksymbol (Figur 4b) der Schaltungsanordnung gemäß Patentanspruch 1;

Figuren 5a und 5b den inneren Aufbau (Figur 5a) und das Blocksymbol (Figur 5b) der Schaltungsanordnung gemäß Patentanspruch 2;

Figur 6 eine Blockschaltung, die eine Zusammenschaltung der in den Figuren 4a und 5a dargestellten Schaltungsanordnung für ein Beispiel der Ordnung N = 4.

4. Schaltungstechnische Realisierung des wurzelnormalisierten adaptiven Schur-RLS-Lattice- Filters

Das normalisierte Verfahren gemäß der algorithmischen Beschreibung in Tabelle 2 ist darüber hinaus dadurch gekennzeichnet, daß es sich ebenfalls mit zwei elementaren Prozessoren realisieren läßt.
Erstens ein Prozessor zur Durchführung der folgenden elementaren Operationen

$$\begin{pmatrix} D^f_{m,j}(t) \\ D^b_{m,j}(t) \end{pmatrix} = \left[ 1 - \rho^2_m(t) \right]^{-1/2} \begin{pmatrix} 1 & \rho_m(t) \\ \rho_m(t) & 1 \end{pmatrix} \begin{pmatrix} D^f_{m-1,j}(t) \\ D^b_{m-1,j-1}(t-1) \end{pmatrix}$$

$$\begin{pmatrix} v_m(t) \\ w_m(t) \end{pmatrix} = \left[ 1 - \rho^2_m(t) \right]^{-1/2} \begin{pmatrix} 1 & \rho_m(t) \\ \rho_m(t) & 1 \end{pmatrix} \begin{pmatrix} v_{m-1}(t) \\ w_{m-1}(t-1) \end{pmatrix}$$

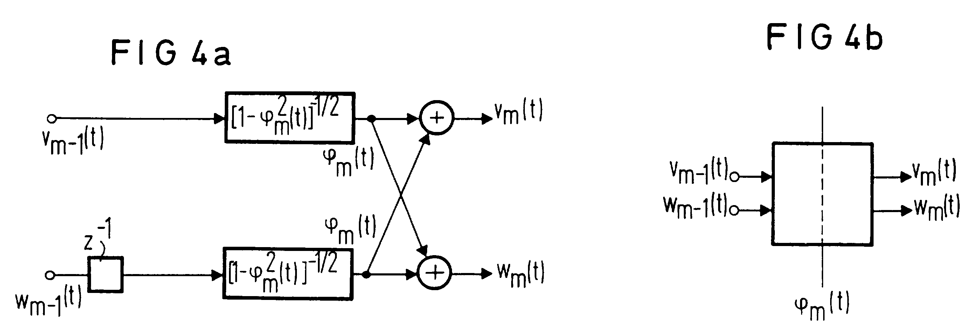

gemäß der algorithmischen Beschreibung aus Tabelle 2. Figur 4a zeigt den inneren Aufbau und Figur 4b zeigt das Blocksymbol dieses Elementarprozessors. Dabei kennzeichnet "*" einen Multiplizierer, "+" kennzeichnet einen Addierer und $z^{-1}$ kennzeichnet ein Register.
Zweitens ein Prozessor zur Durchführung der Operationen

$$\rho_m(t) = - D^f_{m-1,m}(t) R^{-1/2}_{m-1}(t-1)$$

$$\begin{pmatrix} R^{-1/2}_m(t) \\ \times \end{pmatrix} = \left[ 1 - \rho^2_m(t) \right]^{-1/2} \begin{pmatrix} 1 & \rho_m(t) \\ \rho_m(t) & 1 \end{pmatrix} \begin{pmatrix} R^{-1/2}_{m-1}(t-1) \\ 0 \end{pmatrix}$$

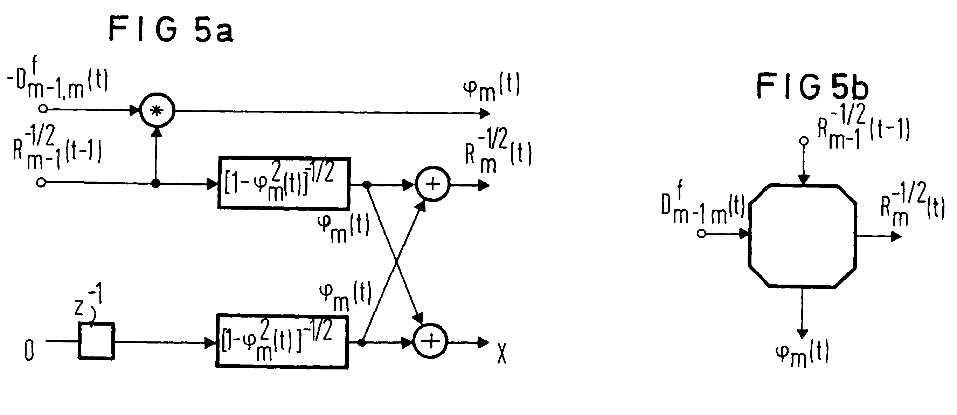

gemäß der algorithmischen Beschreibung aus Tabelle 2. Figur 5a zeigt den inneren Aufbau und Figur 5b zeigt das Blocksymbol dieses Elementarprozessors.

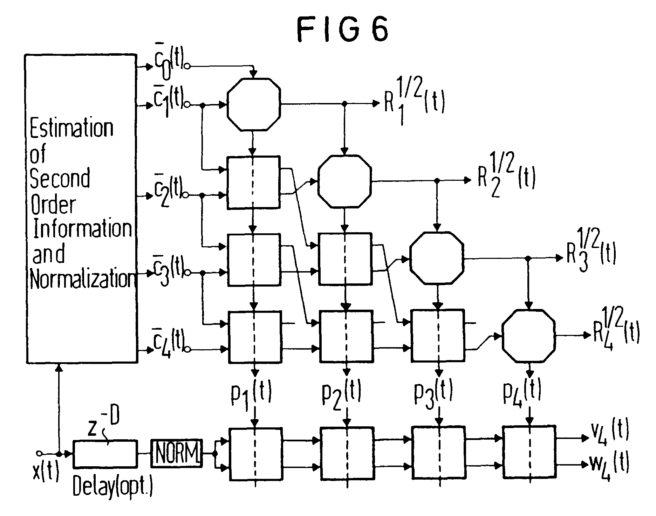

Mit den in Figur 4 und in Figur 5 dargestellten Elementarprozessoren läßt sich eine schaltungstechnische Realisierung der in Tabelle 2 dargestellten algorithmischen Beschreibung angeben. Figur 6 zeigt eine solche schaltungstechnische Realisierung bestehend aus der Zusammenschaltung der in Figur 4 und Figur 5 dargestellten Elementarprozessoren für ein Beispiel der Ordnung N = 4.

Die in Figur 6 gezeigte schaltungstechnischen Realisierung der algorithmischen Beschreibung in Tabelle 2 ist dadurch gekennzeichnet, daß ein zweiter Elementarprozessor aus den Größen $\bar{c}_o(t)$ und $\bar{c}_1(t)$ initialisiert wird und daß daraus die Größe $\rho_1(t)$ berechnet wird, welche auf nur einem Querbus durch N darunterliegende erste Elementarprozessoren geleitet wird. Im Gegensatz zum unnormalisierten Verfahren ist also nur noch ein Querbus erforderlich. Die darauf zu übertragenden Variable $\rho_m(t)$ ist wertebeschränkt, und daher kann dieser Querbus mit einer geringeren Wortbreite als im unnormailiserten Fall ausgeführt werden. Der Elementarprozessor berechnet weiterhin die Größe $R^{1/2}_1(t)$, die nach außen und an einen weiteren zweiten Elementarprozessor, der rechts-unterhalb gelegen ist, geleitet werden. Dies ist ebenfalls nur die Quadratwurzel der beim unnormalisierten Verfahren auftretenden Größe. Der Wertebereich der Größe $R^{1/2}_1(t)$ ist daher wesentlich kleiner als der Wertebereich der im unnormalisierten Verfahren auftretenden Größe $R_1(t)$. Der zweite Elementarprozessor berechnet nun die Größe $\rho_2(t)$, welche wiederum auf einem Querbus durch N -1 darunterliegende Elementarprozessoren geleitet wird. Des weiteren berechnet dieser zweite Elementarprozessor die Größe $R^{1/2}_1(t)$, die nach außen und an einen nächsten rechts-unterhalb in der Anordnung gelegenen Elementarprozessor weitergeleitet wird. In dieser Weise setzt sich die Struktur fort bis zu einem N-ten zweiten Elementarprozessor, welcher die Größe $\rho_m(t)$ berechnet, an einen einzigen darunterliegenden ersten Elementarprozessor weiterleitet und die Größe $R^{1/2}_N(t)$ nach außen weitergibt. Auf diese Weise entsteht die in Figur 1 gezeigte schaltungstechnische Realisierung in Form einer dreiecksförmigen Anordnung bestehend aus N(N+1)/2 elementaren ersten Prozessoren. sowie N elementaren zweiten Prozessoren. In der ersten Spalte der Anordnung werden die obersten N-1 Prozessoren aus den wurzelnormalisierten Momenten zweiter Ordnung initialisiert. Die wurzelnormalisierten Momente zweiter Ordnung werden in einer Anordnung bezeichnet als "Estimation of Second Order Information ans Normalization" aus dem Eingangssignal x(t) geschätzt. Diese Anordnung zur Berechnung der wurzelnormalisierten Momente zweiter Ordnung wird in der Literatur beschrieben [1]. Der unterste Prozessor der ersten Spalte wird aus dem normalisierten Eingangssignal initialisiert, wobei noch eine Verzägerung um D Taktzeiten, bezeichnet mit "Delay (opt)" vorgeschaltet ist. Die horizontale Verschaltung der ersten Prozessoren innerhalb der dreieckigen Anordnung mit Ausnahme der untersten Prozessorenzeile ist dadurch gekennzeichnet. daß jeweils ein Prozessor über zwei Eingänge und zwei Ausgänge verfügt; die Verschaltung ist weiterhin dadurch gekennzeichnet. daß jeder Prozessor von dem direkt links neben ihm sowie von dem direkt schräg links über ihm gelegenen Nachbarprozessor Daten erhält und ist dadurch gekennzeichnet, daß der Prozessor über den oberen Eingang Daten aus dem oberen Ausgang des schräg links über ihm gelegene Prozessors sowie über den unteren Eingang Daten aus dem unteren Ausgang des links neben ihm gelegenen Prozessors erhält. Die Ausnahme bildet die untere Zeile der Anordnung bestehend aus N Prozessoren, welche direkt horizontal miteinander kommunizieren, indem ein Prozessor über seinen oberen Eingang Daten vom oberen Ausgang und über seinen unteren Eingang Daten vom unteren Ausgang des links neben ihm liegenden Prozessors empfängt.

Das Zusammenwirken der Prozessoren in der beschriebenen schaltungstechnischen Realisierung ist wiederum dadurch gekennzeichnet, daß die Prozessoren lokal miteinander kommunizieren.

Das Zusammenwirken der Prozessoren in der beschriebenen schaltungstechnischen Realisierung ist darüberhinaus dadurch gekennzeichnet, daß alle horizontal zwischen den Prozessoren übertragenen Daten wurzelnormalisiert sind, daher einen geringeren Wertebereich in Anspruch nehmen und daher auf Bussen mit geringerer Wortbreite übertragen werden können.

5. Literatur

[1] P. Strobach, *Linear Prediction Theory: A Mathematical Basis for Adaptive Systems.* Springer Series in Information Sciences, vol. 21, Jan. 1990.

[2] P. Strobach, "New Forms of Levinson and Schur Algorithms", IEEE Signal Processing Magazine, Jan. 1991.

[3] J.E. Volder, "The CORDIC trigonometric computing technique", IRE Trans. Electron. Comput., Vol. EC-8, pp. 330-334, 1959.

FÜR jeden Zeitschritt $t = 0, 1, 2, \ldots$ berechne:

Eingangsdaten: Momente 2. Ordnung $\quad c_0(t), c_1(t), \ldots, c_N(t)$

Eingangssignal $\quad x(t)$

$E_0(t) = R_0(t) = c_0(t)$

$e_0(t) = r_0(t) = x(t)$

FÜR $j = 1, 2, 3, \ldots, N$

$\qquad C_{0,j}^f(t) = c_j(t) ; \qquad\qquad C_{0,j}^b(t) = c_j(t)$

FÜR $m = 1, 2, \ldots, N$

$\qquad K_m^f(t) = - C_{m-1,m}^f(t) / R_{m-1}(t-1)$

$\qquad K_m^b(t) = - C_{m-1,m}^f(t) / E_{m-1}(t)$

$\qquad E_m(t) = E_{m-1}(t) + K_m^f(t) C_{m-1,m}^f(t)$

$\qquad R_m(t) = R_{m-1}(t-1) + K_m^b(t) C_{m-1,m}^f(t)$

$\qquad$ FÜR $j = m+1, m+2, \ldots, N$

$$\begin{pmatrix} C_{m,j}^f(t) \\ C_{m,j}^b(t) \end{pmatrix} = \begin{pmatrix} 1 & K_m^f(t) \\ K_m^b(t) & 1 \end{pmatrix} \begin{pmatrix} C_{m-1,j}^f(t) \\ C_{m-1,j-1}^b(t-1) \end{pmatrix}$$

$$\begin{pmatrix} e_m(t) \\ r_m(t) \end{pmatrix} = \begin{pmatrix} 1 & K_m^f(t) \\ K_m^b(t) & 1 \end{pmatrix} \begin{pmatrix} e_{m-1}(t) \\ r_{m-1}(t-1) \end{pmatrix}$$

Tabelle 1

FÜR jeden Zeitschritt $t = 0, 1, 2, \ldots$ berechne:

Eingangsdaten: Momente 2. Ordnung $\quad c_0(t), c_1(t), \ldots, c_N(t)$

$\qquad\qquad$ Eingangssignal $\qquad\qquad x(t)$

Normalisierung: $\qquad\qquad \bar{c}_j(t) = c_j(t)\, c_0^{-1/2}(t) , \qquad 1 \le j \le N$

$$E_0^{1/2}(t) = R_0^{1/2}(t) = c_0^{1/2}(t)$$

$$v_0(t) = w_0(t) = x(t)\, c_0^{-1/2}(t)$$

FÜR $j = 1, 2, 3, \ldots, N$

$$D_{0,j}^f(t) = \bar{c}_j(t) \; ; \qquad\qquad D_{0,j}^b(t) = \bar{c}_j(t)$$

FÜR $m = 1, 2, \ldots, N$

$$\rho_m(t) = -\, D_{m-1,m}^f(t)\, R_{m-1}^{-1/2}(t-1)$$

$$\begin{pmatrix} R_m^{-1/2}(t) \\[2mm] \times \end{pmatrix} = \left[1 - \rho_m^2(t)\right]^{-1/2} \begin{pmatrix} 1 & \rho_m(t) \\[2mm] \rho_m(t) & 1 \end{pmatrix} \begin{pmatrix} R_{m-1}^{-1/2}(t-1) \\[2mm] 0 \end{pmatrix}$$

FÜR $j = m+1, m+2, \ldots, N$

$$\begin{pmatrix} D_{m,j}^f(t) \\[2mm] D_{m,j}^b(t) \end{pmatrix} = \left[1 - \rho_m^2(t)\right]^{-1/2} \begin{pmatrix} 1 & \rho_m(t) \\[2mm] \rho_m(t) & 1 \end{pmatrix} \begin{pmatrix} D_{m-1,j}^f(t) \\[2mm] D_{m-1,j-1}^b(t-1) \end{pmatrix}$$

$$\begin{pmatrix} v_m(t) \\[2mm] w_m(t) \end{pmatrix} = \left[1 - \rho_m^2(t)\right]^{-1/2} \begin{pmatrix} 1 & \rho_m(t) \\[2mm] \rho_m(t) & 1 \end{pmatrix} \begin{pmatrix} v_{m-1}(t) \\[2mm] w_{m-1}(t-1) \end{pmatrix}$$

Tabelle 2

**Patentansprüche**

1. Schaltungsanordnung zur Durchführung einer Elementaroperation eines wurzelnormalisierten Schur-RLS-Lattice-Filters mit Mitteln

   - zur Division eines ersten Eingangssignals ($v_{m-1}(t)$) durch die Quadratwurzel der Differenz aus 1 und dem

Quadrat eines Reflexionskoeffizienten ($\rho_m(t)$),

- zur Verzögerung ($z^{-1}$) eines zweiten Eingangssignals ($w_{m-1}(t)$),
- zur Division des verzögerten zweiten Eingangssignals durch die Quadratwurzel der Differenz aus 1 und dem Quadrat des Reflexionskoeffizienten ($\rho_m(t)$),
- zur Multiplikation der auf diese Weise dividierten und fallweise verzögerten Eingangssignale mit dem Reflexionskoeffizienten ($\rho_m(t)$), wodurch ein erstes und ein zweites Produktsignal berechnet wird,
- zur Addition des dividierten ersten Eingangssignales zum zweiten Produktsignal,
- zur Addition des dividierten und verzögerten zweiten Eingangssignals zum ersten Produktsignal, unter Berechnung und Ausgabe zweier Summensignale.

2. Schaltungsanordnung nach Anspruch 1, bei der ein Multiplizierer (*) vorgesehen ist, welcher den Reflexionskoeffizienten ($\rho_m(t)$) als Produkt des ersten Eingangssignals ($v_{m-1}(t)$) mit einem dritten Eingangssignal (- $D^f_{m-1,m}(t)$) berechnet.

3. Systolische Schaltungsanordnung zur Realisierung eines adaptiven Schur-RLS-Lattice-Filters in Form einer unteren Dreiecksmatrix aus Elementarprozessoren, deren nicht-diagonale Elemente aus Elementarprozessoren eines ersten Typs aufgebaut ist, deren diagonale Elemente aus Elementarprozessoren eines zweiten Typs aufgebaut sind, und der eine Zeilenmatrix aus Elementarprozessoren des ersten Typs nachgeschaltet ist; die Elementarprozessoren des ersten Typs sind Schaltungsanordnungen nach Anspruch 1, die des zweiten Typs Schaltungsanordnungen nach Anspruch 2; die Reflexionskoeffizienten, welche durch einen Elementarprozessor des zweiten Typs berechnet werden, werden den Elementarprozessoren des ersten Typs in den Zeilen der selben Spalte der Matrix zugeführt; die Elementarprozessoren des ersten Typs berechnen aus ihren Eingangssignalen zwei Summensignale, deren erstes dem Elementarprozessor vom ersten Typ in der folgenden Zeile der folgenden Spalte als erstes Eingangssignal, und deren zweites fallweise dem Elementarprozessor vom zweiten Typ oder dem Elementarprozessor vom ersten Typ in der gleichen Zeile der folgenden Spalte als zweites Eingangssignal zugeführt wird; die Elementarprozessoren der ersten Spalte werden durch Momente zweiter Ordnung eingangsseitig initialisiert.

4. Schaltungsanordnung nach Anspruch 3, in welcher die Elementarprozessoren vom ersten und zweiten Typ mit Hilfe von CORDIC-Prozessoren realisiert sind.

## Claims

1. Circuit arrangement for carrying out an elementary operation of a root-normalized Schur RLS lattice filter having means

- for dividing a first input signal ($v_{m-1}(t)$) by the square root of the difference between 1 and the square of a reflection coefficient ($\rho_m(t)$),
- for delaying ($z^{-1}$) a second input signal ($w_{m-1}(t)$),
- for dividing the delayed second input signal by the square root of the difference between 1 and the square of the reflection coefficient ($\rho_m(t)$),
- for multiplying the input signals, divided in this way and delayed as the case may be, by the reflection coefficient ($\rho_m(t)$), a first and a second product signal being calculated thereby,
- for adding the divided first input signal to the second product signal,
- for adding the divided and delayed second input signal to the first product signal while calculating and outputing two aggregate signals.

2. Circuit arrangement according to Claim 1, in which a multiplier (*) is provided which calculates the reflection coefficient ($\rho_m(t)$) as the product of the first input signal ($v_{m-1}(t)$) and a third input signal (-$D^f_{m-1,m}(t)$).

3. Systolic circuit arrangement for realizing an adaptive Schur RLS lattice filter in the form of a lower triangular matrix of elementary processors, whose non-diagonal elements are constructed from elementary processors of a first type, whose diagonal elements are constructed from elementary processors of a second type, and downstream of which a row matrix of elementary processors of the first type is connected; the elementary processors of the first type are circuit arrangements according to Claim 1, whereas those of the second type are circuit arrangements according to Claim 2; the reflection coefficients which are calculated by an elementary processor of the second type are fed to the elementary processors of the first type in the rows of the same column of the matrix; from their input signals, the elementary processors of the first type calculate two aggregate signals, the first of which is fed as first input signal to the elementary processor of the first type in the following row of the following column, and the second of which is fed, as the case may be, as second input signal to the elementary processor of the second type or the elementary processor of the first type in the same row of the following column; the elementary processors of the first column are initialized on the input side by moments of second order.

4. Circuit arrangement according to Claim 3, in which the elementary processors of the first and second types are realized with the aid of CORDIC processors.

**Revendications**

1. Circuit pour l'exécution d'une opération élémentaire d'un filtre du type Schur-RLS-Lattice normalisé en racine, comprenant des moyens

   - pour la division d'un premier signal d'entrée ($v_{m-1}(t)$) par la racine carrée de la différence entre 1 et le carré d'un coefficient de réflexion ($\rho_m(t)$),
   - pour le retardement ($z^{-1}$) d'un deuxième signal d'entrée ($w_{m-1}(t)$),
   - pour la division du deuxième signal d'entrée retardé par la racine carrée de la différence entre 1 et le carré du coefficient de réflexion ($\rho_m(t)$),
   - pour la multiplication des signaux d'entrée divisés et selon les cas retardés de cette façon par le coefficient de réflexion ($\rho_m(t)$), de sorte qu'on calcule des premier et deuxième signaux produits
   - pour l'addition du premier signal d'entrée divisé au deuxième signal produit
   - pour l'addition du deuxième signal d'entrée divisé et retardé au premier signal produit, avec calcul et édition de deux signaux somme.

2. Circuit selon la revendication 1, dans lequel il est prévu un multiplicateur (*) qui calcule le coefficient de réflexion ($\rho_m(t)$) en tant que produit du premier signal d'entrée ($v_{m-1}(t)$) par un troisième signal d'entrée ($-D^f_{m-1,m}(t)$).

3. Circuit systolique pour la réalisation d'un filtre du type Schur-RLS-Lattice normalisé en racine adaptatif sous la forme d'une matrice triangulaire inférieure de processeurs élémentaires dont les éléments non diagonaux sont construits à partir de processeurs élémentaires d'un premier type, dont les éléments diagonaux sont construits à partir de processeurs élémentaires d'un deuxième type, et en aval duquel est placée une matrice de lignes composée de processeurs élémentaires du premier type ; les processeurs élémentaires du premier type sont des dispositifs selon la revendication 1, ceux du deuxième type sont des dispositifs selon la revendication 2 ; les coefficients de réflexion qui sont calculés par un processeur élémentaire du deuxième type, sont transmis aux processeurs élémentaires du premier type contenus dans les lignes de la même colonne de la matrice ; les processeurs élémentaires du premier type calculent à partir de leurs signaux d'entrée deux signaux de somme dont le premier est transmis au processeur élémentaire du premier type contenu dans la ligne suivante de la colonne suivante en tant que premier signal d'entrée et dont le deuxième est selon les cas transmis au processeur élémentaire du deuxième type ou au processeur élémentaire du premier type contenu dans la même ligne de la colonne suivante en tant que deuxième signal d'entrée ; les processeurs élémentaires de la première colonne sont initialisés côté entrée par des moments du deuxième ordre.

4. Circuit selon la revendication 3, dans lequel les processeurs élémentaires des premier et deuxième types sont réalisés à l'aide de processeurs CORDIC.

# FIG 1a

# FIG 1b

FIG 2a

FIG 2b

# FIG 3

EP 0 523 595 B1

EP 0 523 595 B1

# FIG 4a

$v_{m-1}(t)$ → $[1-\varphi_m^2(t)]^{1/2}$

$z^{-1}$

$w_{m-1}(t)$ → $[1-\varphi_m^2(t)]^{-1/2}$

$\varphi_m(t)$

$\varphi_m(t)$

→ $v_m(t)$

→ $w_m(t)$

# FIG 4b

$v_{m-1}(t)$ →

$w_{m-1}(t)$ →

→ $v_m(t)$

→ $w_m(t)$

$\varphi_m(t)$

EP 0 523 595 B1

## FIG 5a

$-D^f_{m-1,m}(t)$

$R^{-1/2}_{m-1}(t-1)$

$\varphi_m(t)$

$[1-\varphi^2_m(t)]^{1/2}$

$R^{-1/2}_m(t)$

$\varphi_m(t)$

$z^{-1}$

$0$

$\varphi_m(t)$

$[1-\varphi^2_m(t)]^{-1/2}$

$X$

## FIG 5b

$R^{-1/2}_{m-1}(t-1)$

$D^f_{m-1\,m}(t)$

$R^{-1/2}_m(t)$

$\varphi_m(t)$

# FIG 6